# EUROPEAN PATENT APPLICATION

(11) **EP 2 009 976 A1**
(43) Date of publication of application: **31.12.2008**
(21) Application number: 07739446.8
(22) Date of filing: 23.03.2007
(51) Int. Cl.: H05K 9/00, G09F 9/00

(54) **METHOD FOR PRODUCING CONDUCTIVE SUBSTRATE AND CONDUCTIVE SUBSTRATE**

(30) Priority: 05.04.2006 JP 2006103854
(71) Applicant: TORAY INDUSTRIES, INC., Tokyo 103-8666 (JP)
(72) Inventor: TANAKA, Shotaro, Kusatsu-shi Shiga 525-0032 (JP); OHASHI, Junpei, Otsu-shi Shiga 520-0842 (JP); TAKADA, Yasushi, Otsu-shi Shiga 520-0842 (JP)
(74) Representative: Kador & Partner
(86) International application number: PCT/JP2007/056005
(87) International publication number: WO 2007/114076

(57) **Abstract**

Disclosed is a method for producing a conductive substrate wherein a metal fine particle layer is laminated onto at least one surface of a base in a network form. This method comprises a step for treating the metal fine particle layer with an organic solvent, and a following step for treating the metal fine particle layer with an acid. Also disclosed is a conductive substrate produced by such a method. This method enables to produce a conductive substrate, which has transparency and high conductivity and is thus suitable for electromagnetic shielding films and the like, with high productivity.

## Description

### Technical Field of the Invention

The present invention relates to a method for producing a conductive substrate excellent in transparency, conductivity and productivity, and a conductive substrate made by the production method, and more specifically, relates to a conductive substrate for an electromagnetic shielding substrate used suitably for a flat panel display such as a plasma display panel or a liquid crystal television, and a method for producing the conductive substrate.

### Background Art of the Invention

A conductive substrate is used as a circuit material for various equipment, and it is used as an electromagnetic shielding substrate or for use of a solar battery.

An electromagnetic shielding substrate is used for the purpose for suppressing various electromagnetic waves radiated from electronic equipment such as household electric equipment, portable telephones, personal computers and televisions. In particular, among household electric equipment remarkably developed, strong electromagnetic waves are radiated also from flat panel display such as plasma display panels and liquid crystal televisions, and an influence to human body may be worried. In these displays, because an image is observed with a relatively small distance and, as the case may be, for a long time, an electromagnetic shielding substrate for suppressing the electromagnetic waves is needed, and investigated earnestly.

Generally, as an electromagnetic shielding substrate, a transparent conductive substrate is used, and various methods for producing conductive substrates for electromagnetic shielding substrates are employed. For example, a mesh-like conductive film whose conductive part is formed from copper is made by laminating a copper foil onto a polyester film, patterning a systematic mesh form by photolithography, and etching the copper foil in the mesh form (Patent document 1).

Besides, as a method for producing a conductive substrate provided with a patterned conductive layer, for example, a method is proposed wherein a metal fine particle solution is printed on a substrate to form a conductive layer of metal fine particles (Patent documents 2 and 3).

Further, although generally a high-temperature or long-time heat treatment is necessary to increase the conductivity of a metal fine particle layer, for example, in a case where a thermoplastic resin such as a polyester film is used as a substrate, the high-temperature or long-time heat treatment causes a problem of deformation of the thermoplastic resin. For this problem, a method is proposed for increasing the conductivity of the metal fine particle layer without carrying out the high-temperature or long-time heat treatment (Patent documents 2 to 5).
Patent document 1: JP-A-2001-210988
Patent document 2: JP-A-2004-79243
Patent document 3: JP-A-2004-207558
Patent document 4: JP-A-2005-32458
Patent document 5: JP-A-2004-127851

### Disclosure of the Invention

### Problems to be solved by the Invention

However, there are the following problems in the above-described conventional technologies.
Although the method described in Patent document 1 for etching a copper foil is an excellent method for obtaining a mesh form very high in accuracy, usually, the step for laminating the copper foil, the lithography step and the etching step are bad in yield, and product loss is liable to occur in the respective steps. Particularly in the etching step, there are many environmental problems such as generation of harmful waste liquid. Further, if a copper foil is used as a raw material and thereafter the copper foil is etched to try to improve the transparency, it is necessary to dissolve out most part of the copper foil by etching to turn it into a waste liquid, and there are many problems also in raw material recycle.

Further, in the method described in Patent documents 2-5 for obtaining a conductive layer of metal fine particles by printing of metal fine particle solution, because a sufficiently high conductivity cannot be obtained only by printing, it is necessary to take some treatment. As a treatment for increasing the conductivity, although a method for supplying electric current to the metal fine particle layer and sintering it is proposed in Patent document 2, there is a problem requiring special device and operation for the supply of electric current such as a power source and connection of terminals.

Furthermore, as methods for increasing the conductivity, although Patent documents 3-5 disclose to provide a metal fine particle layer via an acceptor layer for ink jet, via interlayer limited in average surface roughness and comprising a hydrophilic resin, or via an acceptor layer containing an inorganic filler, it is necessary to provide a particular acceptor layer or interlayer onto a base beforehand, and therefore, because the number of production steps increases, there is a problem decreasing the productivity.

Accordingly, an object of the present invention is to solve the problems in the above-described conventional technologies and to provide a method for efficiently producing a conductive substrate having a transparency and a conductivity, and a conductive substrate made by the method.

### Means for solving the Problems

To achieve the above-described object, a method for producing a conductive substrate according to the present invention wherein a metal fine particle layer is laminated onto at least one surface of a base in a network form, the method comprises the steps of treating the metal fine particle layer with an organic solvent, and thereafter, treating the metal fine particle layer with an acid.

The present invention also provides a conductive substrate produced by such a method. This conductive substrate is used suitably, for example, for an electromagnetic shielding substrate for a plasma display.

### Effect according to the Invention

In the method for producing a conductive substrate according to the present invention, by carrying out a specified treatment to a metal fine particle layer with a network form, excellent transparency, conductivity and productivity of the conductive substrate can be obtained. This method is a production method particularly employed suitably for making a conductive substrate using a thermoplastic resin film as its base. The conductive substrate obtained by the production method according to the present invention can be suitably used as an electromagnetic shielding substrate used for a flat panel display such as a plasma display panel or a liquid crystal television.

### Brief explanation of the drawings

[Fig. 1] Fig. 1 is a partial plan view of a conductive substrate showing an example of a metal fine particle layer with a random network structure.
[Fig. 2] Fig. 2 is a partial plan view of a conductive substrate showing another example of a metal fine particle layer with a random network structure.

### Explanation of symbols

1, 2: random network structure

### The Best mode for carrying out the Invention

Hereinafter, a method for producing a conductive substrate and a conductive substrate according to the present invention will be explained in detail together with desirable embodiments.
Although the size of the metal fine particles in the present invention is not particularly limited, the number average particle diameter thereof is preferably in a range of 0.001-5.0µm. If the number average particle diameter of the metal fine particles is more than this range, there is a case where the metal layer is hardly formed in a network form. The number average particle diameter of the metal fine particles is preferably in a range of 0.001-2.0µm, more preferably in a range of 0.002-1.5µm, and particularly preferably in a range of 0.002-0.2µm. In a case where the number average particle diameter is less than 0.001µm, the continuous contact between the metal fine particles is frequently interrupted, and as a result, there is a case where an enough conductivity cannot be obtained. In a case where the number average particle diameter is greater than 5.0µm, the advantage for increasing the conductivity due to the step being treated with an organic solvent and the following step being treated with an acid in the present invention described later is hardly obtained, and there is a case where an enough conductivity cannot be obtained. The particle diameter distribution of the metal fine particles contained in the metal fine particle layer either may be large or may be small, and either may be non-uniform or may be uniform. The metal used for the metal fine particles is not particularly restricted, and as the metal, platinum, gold, silver, copper, nickel, palladium, rhodium, ruthenium, bismuth, cobalt, iron, aluminum, zinc, tin, etc. can be exemplified. One kind of metal may be used, and two or more kinds may be combined.

The metal fine particle layer is a layer formed by the above-described metal particles, and except the metal fine particles, it can contain other various additives, for example, inorganic components, organic components such as a dispersant, a surfactant, a protective resin, an antioxidant, a thermal resistance stabilizer, a weather resistance stabilizer, an ultraviolet ray absorbent, a pigment, a dye, organic or inorganic fine particles, a filler, an antistatic agent, etc.

In the present invention, by laminating the metal fine particle layer in a network form, a transparent and conductive substrate can be obtained, and by applying a specified treatment to the metal fine particle layer, excellent transparency, conductivity and productivity can be obtained. The total light transmittance of the conductive substrate produced by the production method according to the present invention is preferably 50% or more, more preferably 60% or more, further more preferably 70% or more, and most preferably 75% or more. If the light transmittance is less than 50%, there is a case where a problem occurs in the transparency of the conductive substrate.

The method for laminating the metal fine particle layer onto the base is not particularly restricted, and a metal fine particle layer may be formed in a structure connected in a network form.

For example, it can be selected from various methods such as a method for printing a solution of a compound capable of forming the metal fine particle layer, such as a solution of metal fine particles, a solution of metal oxide fine particles, a solution of an organic metal compound or a solution prepared by mixing two or more kinds of these solutions, in a network form, a method for applying the above-described solution in a network form, a method for physically chipping or chemically etching the metal fine particle layer so as to form a network form after laminating the above-described solution on the entire surface of the base, or a method for forming grooves at a network form on at least one surface of the base beforehand by digging or stamping the base and filling the grooves with the above-described solution.

In a case where a network structure is formed using a solution of a compound capable of forming the metal fine particle layer, for example, the method for printing or application can be suitably employed by using a solution of solid components whose main component comprises particles formed by metal fine particles and an organic component such as a dispersant (a metal colloidal solution). As the solvent for the metal colloidal solution, water or various organic solvents can be used.

In the present invention, as the formation of a compound capable of forming the metal fine particle layer, it is preferred to use a solution prepared, for example, by dispersing or dissolving at least one selected from the group consisting of metal fine particles, metal oxide fine particles and organic metal compound in a solvent. A solution, prepared by, after preparing the above-described solution, adding thereto a resin component or other various additives such as an antioxidant, a thermal resistance stabilizer, a weather resistance stabilizer, an ultraviolet ray absorbent, an organic lubricant, a pigment, a dye, organic or inorganic fine particles, a filler, an antistatic agent, a nucleator, etc. by an amount that does not damage the property, can also be suitably used.

On the other hand, in a case where a solution, prepared by dispersing the above-described compound capable of forming the metal fine particle layer in a resin component by, for example, kneading the compound into the resin component, is used, because there is a case where the advantage for increasing the conductivity by the acid treatment of the present invention is not sufficiently exhibited and an excellent conductivity cannot be obtained, such a condition is not preferred. Further, even by a solution prepared by dispersing the above-described compound capable of forming the metal fine particle layer in a resin component and thereafter adjusting the viscosity by adding a solvent thereto, or even by a solution prepared by kneading the above-described compound capable of forming the metal fine particle layer into a resin component together with the resin component and a solvent, because there is a case where the advantage for increasing the conductivity by the acid treatment of the present invention is not sufficiently exhibited and an excellent conductivity cannot be obtained, such a condition is not preferred.

In a case where a solution prepared by dispersing or dissolving at least one selected from the group consisting of metal fine particles, metal oxide fine particles and organic metal compound in a solvent is used, surprisingly, it has been found that the advantage due to the acid treatment according to the present invention can be easily obtained by an acid solution with a low concentration. In a case using a high-concentration acid, there is a case reducing the workability and deteriorating the productivity, and such a condition is not preferred. In a case where a solution prepared by dispersing the metal fine particles in a resin component by kneading the particles into the resin component is used, there is a case where an excellent conductivity cannot be obtained even if a low-concentration acid solution is used.

The mixing ratio of the metal fine particles contained in the metal fine particle layer to the resin component is preferably 900 parts by weight of the metal fine particles or more relative to 100 parts by weight of the resin component, more preferably 1,900 parts by weight or more, further more preferably 4,900 parts by weight or more, and it is most preferable that the resin component is not contained.

As the method for adjusting the metal fine particles, for example, can be used a chemical method for reducing a metal in a liquid phase ion to prepare a metal atom and growing it to a nano particle through an atomic cluster, a method for cold trapping metal fine particles prepared by evaporating a bulk metal in an inert gas, and a physical method for breaking a metal thin membrane formed by vacuum deposition onto a polymer thin film by heating, and dispersing metal nano particles in a polymer at a solid phase state.

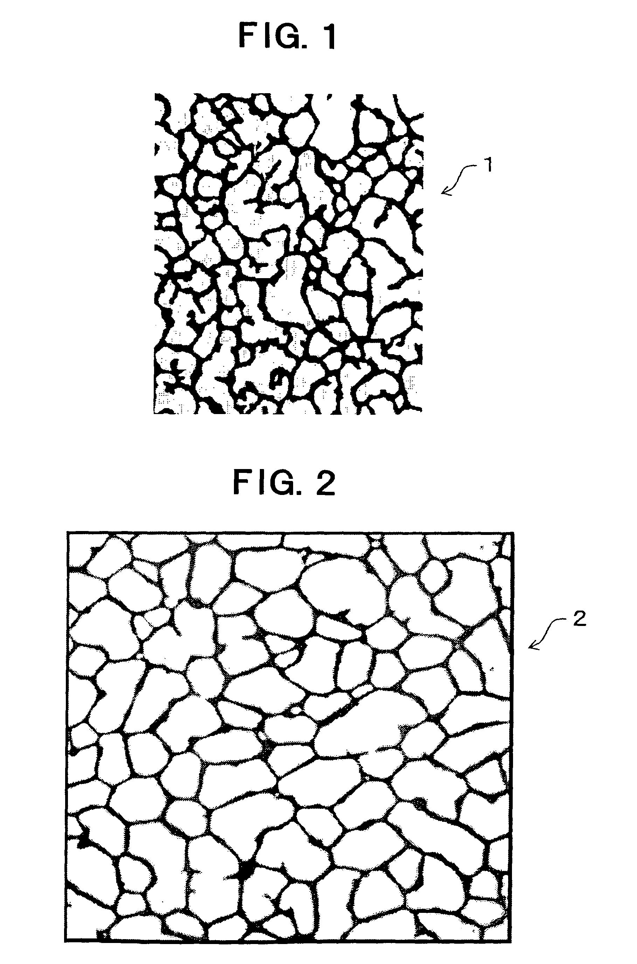

The network structure of the metal fine particle layer in the present invention either may be a systematic structure or may be an unsystematic (random) structure. In a case where the conductive substrate produced by the production method according to the present invention is used, for example, as an electromagnetic shielding substrate of a flat panel display, it is preferred to form the network structure as a random structure, because Moire phenomenon does not occur. Moire phenomenon means "a mottle of fringes generated when points or lines, which are systematically distributed geometrically, are overlapped", and there is a description in a Japanese dictionary "Koujien" that "a mottle of fringe pattern generated when points or lines, which are systematically distributed geometrically, are overlapped, and it is liable to occur when a halftone is copied using a halftone printed manuscript and the like.", and in the field of a flat panel display, a fringe pattern is generated on the display. This is because, in a case where the network-form metal fine particle layer of a conductive substrate provided on the front surface of the display is formed as a systematic structure, Moire phenomenon occurs by an interaction between the metal fine particle layer and a systematic lattice-like partition wall for partitioning respective picture elements of RGB (R: Red, G: Green, B: Blue) and the like in the display main body. These are arranged systematically from each other, and in particular, because it is impossible to change the systematic form of the lattice-like partition wall for partitioning picture elements, as one effective method for solving the Moire phenomenon, a method for making the network structure of the conductive substrate random can be exemplified. The random network structure is specified by an image observed by a scanning electron microscope, and the network structure is observed as a state where the forms and sizes of space parts thereof are nonuniform in shape, that is, observed as a random state. Therefore, the shape of the parts forming the network, namely, the shape of the line-like parts, is also observed as a nonuniform state, that is, at a random state. Examples of the random network structures are shown in Fig. 1 (random network structure 1) and Fig. 2 (random network structure 2), but the structure is not limited thereto.

In methods for printing or etching or forming grooves in order to form a random network structure, it is difficult to form a network structure random and having good transparency and conductivity. Concretely, because in printing the width of the lines becomes large, there is a case where the transparency is reduced, and it is difficult to achieve both good transparency and conductivity. In the method for etching or for forming grooves, because linear lines are likely to be formed, the random feature is poor, and there is a case where Moire fringes are strongly exhibited.

In the present invention, not by the above-described methods for printing, etching and forming grooves, for example, as disclosed in JP-A-10-340629, a method is preferable wherein a fine particle network is formed utilizing a phenomenon in which fine particles are partially gathered to form a network line by applying a solution for forming a metal fine particle layer onto a base, namely, a so-called self-assembly phenomenon. By using such a method, the network is liable to become random, and a network structure having thin lines and exhibiting a better conductivity by the step of the treatment with an organic solvent and the following step of the treatment with an acid in the present invention described later can be formed, and therefore, a substrate having random network structure and satisfying both good transparency and conductivity is easily obtained. Namely, it is preferred to use a solution which is self-assembled. Here, the "solution which is self-assembled" means a solution which naturally forms a network structure on a base when it is applied and left on one surface of the base. As such a solution for forming the metal fine particle layer, for example, CE102-2, CE103-7, etc. produced by Cima NanoTech Corporation can be used.

In the present invention, the conductivity of the metal fine particle layer can be increased by a step for treating the metal fine particle layer with an organic solvent and a following step for treating it with an acid.

The acid in the present invention is not particularly limited, and can be selected from various organic acids and inorganic acids. As the organic acids, acetic acid, oxalic acid, propionic acid, lactic acid, benzene sulfonic acid, etc. can be exemplified. As the inorganic acids, hydrochloric acid, sulfuric acid, nitric acid, phosphoric acid, etc. can be exemplified. These may be either strong acid or weak acid. Preferably, it is acetic acid, hydrochloric acid, sulfuric acid, or an aqueous solution thereof, and more preferably, it is hydrochloric acid, sulfuric acid, or an aqueous solution thereof.

At which stage the metal fine particle layer is treated with an acid in the process for producing the conductive substrate is not particularly restricted, and either the metal fine particle layer may be treated with an acid after being laminated onto a base in a network form, or the metal fine particles are laminated over the entire surface of a base and then treated with an acid and thereafter, the layer of the metal fine particles may be formed in a network form by etching and the like. However, a method for laminating the metal fine particles onto a base in a network form and thereafter treating the layer with an acid is suitably employed from a high advantage for increasing the conductivity and a good efficiency in productivity. Before or after the treatment with an acid, another layer may be laminated on the base laminated with the metal fine particle layer by being printed or applied. Further, before or after the treatment with an acid, the base laminated with the metal fine particle layer may be dried, heat treated, or exposed in radiated ultraviolet rays.

As the time for the treatment with an acid, even several minutes or less may be sufficient, and even if the treatment time is more increased, there is a case where the advantage for improving the conductivity is not increased or a case where the advantage for improving the conductivity is deteriorated. The time for the treatment with an acid is preferably, for example, in a range of 15 seconds to 60 minutes, more preferably in a range of 15 seconds to 30 minutes, further more preferably in a range of 15 seconds to 2 minutes, and particularly preferably in a range of 15 seconds to 1 minute.

As the temperature for the treatment with an acid, a room temperature is enough. If it is performed at a high temperature, there is a case where vapor of the acid is generated and it causes degradation of surrounding metal devices or a case where, when a thermoplastic resin film is used as a base, the base is whitened and the transparency is damaged, and therefore, such a condition is not preferred. The treatment temperature is preferably 40°C or lower, more preferably 30°C or lower, and further more preferably 25°C or lower.

The method for treatment with an acid is not particularly restricted, for example, may be employed a method for dipping the base laminated with a metal fine particle layer in an acid or an acid solution, a method for applying an acid or acid solution onto the metal fine particle layer, or a method for bringing a vapor of an acid or an acid solution into contact with the metal fine particle layer. Among these methods, a method for bringing an acid liquid into contact directly with the base, such as the method for dipping the base laminated with the metal fine particle layer in an acid solution or the method for applying an acid or acid solution onto the metal fine particle layer, is preferred because the advantage for improving the conductivity is excellent. Namely, as the condition for the treatment with an acid, a condition, where at a temperature of 40°C or lower a base laminated with a metal fine particle layer is dipped in an acid solution or an acid or an acid solution is applied on the metal fine particle layer, is preferred.

In a case where an acid solution is used, the concentration of an acid is preferably 10 mol/L or lower, more preferably 5 mol/L or lower, and further more preferably 1 mol/L or lower. If the concentration of acid solution is higher, there is a case where the workability is reduced and the productivity is deteriorated, or when a thermoplastic resin film is used as a base, there is a case where the base is whitened and the transparency is damaged, and therefore, such a condition is not preferred. Further, if the acid concentration is too low, because the advantage due to the treatment with an acid cannot be obtained, the concentration is preferably 0.05 mol/L or higher, and more preferably 0.1 mol/L or higher.

Where, in a case where the metal fine particle layer is formed from metal fine particles with a number average particle diameter of 0.2µm or less, because the advantage due to the treatment with an acid according to the present invention is enough exhibited even by an acid with the above-described low concentration, it is particularly preferred that the number average particle diameter of metal fine particles is 0.2µm or less.

Further, as aforementioned, in a case where a condition is employed wherein a compound capable of forming metal fine particles such as metal fine particles, metal oxide fine particles or an organic metal compound is kneaded into a resin component and it is dispersed in the resin component, there is a case where an excellent conductivity cannot be obtained by the above-described low-concentration acid solution.

On the other hand, in a case where a solution prepared by dispersing or dissolving at least one selected from the group consisting of metal fine particles, metal oxide fine particles or an organic metal compound in a solvent is used, an excellent conductivity can be obtained even by a low-concentration acid solution.

Although the mechanism, wherein an advantage for increasing the conductivity can be exhibited in a case where a solution prepared by dispersing or dissolving at least one selected from the group consisting of metal fine particles, metal oxide fine particles or an organic metal compound in a solvent is used and on the contrary there is a case where an excellent conductivity cannot be obtained in a case of employing a condition wherein a compound capable of forming metal fine particles is dispersed in a resin component, is not clear, it is supposed as follows.

Namely, with the dispersion state in the resin component, because parts with a high concentration and with a low concentration of the compound capable of forming the metal fine particles are liable to occur and the dispersion state of the compound capable of forming the metal fine particles is non-uniform, a place having a remarkably large amount of resin component filling a portion between metal fine particles is generated in the metal fine particle layer formed, even if the content of the resin component is small, and in order to remove the resin, there is a case where a treatment such as one for etching the resin component is needed. On the other hand, in the solution prepared by dispersing or dissolving at least one selected from the group consisting of metal fine particles, metal oxide fine particles or an organic metal compound in a solvent, because the compound capable of forming the metal fine particles is likely to be in a uniform dispersion condition at which the unevenness of concentration does not occur depending upon places, in the formed metal fine particle layer a place with another insulation component filling between the metal fine particles at a remarkably large amount is hardly generated. Therefore, a treatment such as one for etching another insulation component with a high-concentration acid is not needed, and it is supposed that an enough advantage due to the treatment can be exhibited even by a low-concentration acid solution.

Further, in the present invention, it is necessary to treat the metal fine particle layer with an organic solvent before the treatment with an acid. By combining the treatment with an organic solvent and the treatment with an acid in this order, it becomes possible to obtain an excellent conductivity by a treatment for a very short time and without requiring a high temperature. Further, it becomes possible to obtain an excellent conductivity without a treatment using a high-concentration acid. Therefore, even in a case where a thermoplastic resin film is used, it is not necessary to employ a condition having a possibility for whitening the thermoplastic resin film or damaging the transparency, and it becomes possible to obtain an excellent conductivity.

As the stage for treating the metal fine particle layer with an organic solvent, it may be treated with an organic solvent after the metal fine particle layer is laminated on the base in a network form, or, it may be treated with an organic solvent after the metal fine particles are laminated on the entire surface of the base, and thereafter, by etching and the like, the metal fine particle layer may be formed in a network shape. Among these, the method for treating the metal fine particle layer after laminating the layer in a network form is suitably employed because of an excellent advantage for increasing the conductivity and an efficient productivity. Another layer may be laminated onto the base laminated with the metal fine particle layer by printing or applying it, before or after the treatment with an organic solvent. Further, before or after the treatment with an organic solvent, the base laminated with the metal fine particle layer may be dried, heat treated, or treated by radiation of ultraviolet rays.

Between the step of the treatment with an organic solvent and the step of the treatment with an acid, another step may be carried out, such as a step for laminating another layer onto an opening portion of a network formed by the metal fine particle layer and the like by printing or applying it.

A room temperature is enough as the temperature for the treatment with an organic solvent. If the treatment is carried out at a high temperature, in a case where a thermoplastic resin film is used as the base, the base may be whitened or may be damaged in transparency, and therefore, such a condition is not preferred. The treatment temperature is preferably 40°C or lower, more preferably 30°C or lower, and further more preferably 25°C or lower.

The method for the treatment with an organic solvent is not particularly restricted, for example, may be employed a method for dipping the base laminated with a metal fine particle layer in a solution of organic solvent, a method for applying an organic solvent onto the metal fine particle layer, or a method for bringing a vapor of an organic solvent into contact with the metal fine particle layer. Among these methods, the method for dipping the base laminated with a metal fine particle layer in a solution of organic solvent, or the method for applying an organic solvent onto the metal fine particle layer, is preferred because of obtaining an excellent advantage for increasing the conductivity.

When examples of the organic solvent are exemplified, can be used an alcohol group such as methyl alcohol, ethyl alcohol, isopropyl alcohol, n-butanol, isobutanol, 3-methoxy-3-methyl-1-butanol, 1,3-butane diol or 3-methyl-1,3-butane diol, a ketone group such as acetone, methylethylketone, methylisobutylketone, cyclohexanone or cyclopentanone, an ester group such as ethyl acetate or butyl acetate, an alkane group such as hexane, heptane, decane or cyclohexane, a bipolar aprotic solvent such as N-methyl-2-pyrolidone, dimethylformamide, dimethylacetoamide or dimethylsulfooxide, toluene, xylene, aniline, ethylene glycol butylether, ethylene glycol, ethylether, ethylene glycol methyether, chloroform, etc. and a mixed solvent thereof. Among these, a solvent containing a ketone group, an ester group, toluene is more preferred because of an excellent advantage for increasing the conductivity, and a most preferable solvent is a ketone group.

As the organic solvent, a solvent diluted with water may be used. The mixing ratio of organic solvent to water is preferably 5/95 or more at a weight ratio, more preferably 50/50 or more, further more preferably 70/30 or more, and most preferably a ratio close to 100/0.

As the time for the treatment with an organic solvent, even several minutes or less is sufficient, and even if the treatment time is more increased, there is a case where the advantage for improving the conductivity is not increased or a case where the advantage for improving the conductivity is deteriorated. The time for the treatment with an organic solvent is preferably in a range of 1 second to 5 minutes, more preferably in a range of 1 second to 1 minute, further more preferably in a range of 1 second to 30 seconds, and particularly preferably in a range of 1 second to 15 seconds.

With respect to the conductivity of the metal fine particle layer in the present invention, it is preferred that the specific surface resistance is 10Ω/□ or less. It is more preferably 7Ω/□ or less, and further more preferably 5Ω/□ or less. If the specific surface resistance is 10Ω/□ or less, because a load due to a resistance becomes small when the conductive substrate is used by being supplied with an electric current, such a condition is preferred from the viewpoints that exothermic can be suppressed and that it can be used at a low voltage. Further, for example, in a case where the substrate is used as a conductive substrate for an electromagnetic shielding substrate of a flat panel display such as a plasma display panel or a liquid crystal television, because the electromagnetic shielding property becomes good, such a condition is preferred. The specific surface resistance can be determined, for example, by leaving the substrate in a regular condition (23°C, relative humidity: 65%) for 24 hours, and thereafter, determining it under the atmospheric condition based on JIS-K-7194 using "Loresta-EP" (produced by Mitsubishi Chemical Corporation, Type: MCP-T360).

The base in the present invention is not particularly restricted, and therefor, various bases such as a glass and a resin can be used. Further, a base prepared by combining two kinds of bases such as a glass and a resin by laminating and the like may be used.

In the present invention, because a heat treatment at a high temperature for a long time is not required in order to increase the conductivity of the metal fine particle layer, a thermoplastic resin film can be used as the base. The structure wherein the base is formed by a thermoplastic resin film is preferred from the viewpoints of transparency, flexibility and processing ability. The "thermoplastic resin film" in the present invention means a generic term of a film molten or softened by heat and it is not particularly restricted, and as a typical resin, can be used a polyester film, a polyolefin film such as a polypropylene film or a polyethylene film, a polylactic film, a polycarbonate film, an acrylic-based film such as a polymethylmethacrylate film or a polystyrene film, a polyamide film such as a nylon film, polyvinyl chloride film, polyurethane film, a fluorine-based film, a polyphenylene sulfide film, etc.

These may be a homopolymer or a copolymer. Among these, from the viewpoints of mechanical properties, dimensional stability and transparency, a polyester film, a polypropylene film, a polyamide film, etc. are preferred, and further, from the viewpoints of mechanical strength and wide use, a polyester film is particularly preferred.

In the polyester film, the "polyester" means a generic term of a polymer in which an ester bond is a main bonding chain of its principal chain, and can be preferably used a polymer whose main structural component comprises at least one component selected from the group consisting of ethylene terephthalate, propylene terephthalate, ethylene-2,6-naphthalate, butylene terephthalate, propylene-2,6-naphthalate, ethylene-α, β-bis(2-chlorophenoxy)ethane-4,4'-dicarboxylate. Although each component may be used solely or two or more components may be used together, especially when quality, economic property, etc. are totally considered, particularly a polyester whose main component is ethylene terephthalate, that is, polyethylene terephthalate is preferably used. Further, in a case where a heat or a shrinkage stress operates to a base, polyethylene-2,6-naphthalate excellent in thermal resistance and stiffness is further preferred. To these polyesters, another dicarboxylic component or diol component may be further copolymerized partially, preferably at 20 mol% or less.

Further, in this polyester, various additives, for example, an antioxidant, a thermal resistance stabilizer, a weather resistance stabilizer, an ultraviolet ray absorbent, an organic lubricant, a pigment, a dye, organic or inorganic fine particles, a filler, an antistatic agent, a nucleator, etc. may be added by an amount that does not damage the property.

The intrinsic viscosity (determined in o-chlorophenol at 25°C) of the above-described polyester is preferably in a rang e of 0.4 to 1.2 dl/g, and more preferably in a range of 0.5 to 0.8 dl/g, for carrying out the present invention.

The polyester film using the above-described polyester is preferably a biaxially oriented film. Generally, the biaxially oriented polyester film means a film wherein a non-stretched polyester sheet or film is stretched in longitudinal and transverse directions at each draw ratio of about 2.5-5 times, respectively, and thereafter, heat treated and completed in crystal orientation, and it exhibits a pattern of biaxial orientation.

The thickness of the polyester film is not particularly restricted, and although it may be appropriately selected depending upon the use and the kind, from the viewpoints of mechanical strength and handling ability, usually it is preferably in a range of 10 to 500µm, more preferably in a range of 38 to 250µm, and most preferably in a range of 75 to 150µm. Further, the polyester film base may be a composite film prepared by coextrusion. On the other hand, a base prepared by laminating obtained films by various methods can also be used.

Onto the conductive substrate according to the present invention, various layers other than the base and the metal fine particle layer may be laminated. Although it is not particularly restricted, for example, a primer coating layer and the like may be provided between the base and the metal fine particle layer in order to improve the adhesive property, a protective layer may be provided on the metal fine particle layer, and an adhesive layer, a releasing layer, a protective layer a layer for giving an adhesive property, a weather resistance layer, etc. may be provided on one surface or both surfaces of the base.

Hereinafter, the method for producing a conductive substrate according to the present invention will be explained by exemplifying more concretely, but it is not limited thereto. In a first method, a solution of silver fine particles is printed on a biaxially oriented polyester film in a lattice form, and a silver fine particle layer is laminated at a lattice-like network structure. Thereafter, in order to treat the silver fine particle layer with an organic solvent, it is put in acetone together with the biaxially oriented polyester film, and they are left at that condition for a time of about several seconds to 1 minute. Then, the organic solvent adhered to the film is dried, and thereafter, in order to treat the silver fine particle layer with an acid, it is put in 0.1N hydrochloric acid together with the biaxially oriented polyester film, and they are left at that condition for a time of about several seconds to 60 minutes. Thereafter, the biaxially oriented polyester film is taken out, and washed by water and dried.

In a second method, a solution in which silver fine particles are self-assembled is applied to a biaxially oriented polyester film, and a silver fine particle layer is laminated at a random network structure. Thereafter, in order to treat the silver fine particle layer with an organic solvent, it is put in acetone together with the biaxially oriented polyester film, and they are left at that condition for a time of about several seconds to 1 minute. Then, the organic solvent adhered to the film is dried, and thereafter, in order to treat the silver fine particle layer with an acid, it is put in 0.1N hydrochloric acid together with the biaxially oriented polyester film, and they are left at that condition for a time of about several seconds to 60 minutes. Thereafter, the biaxially oriented polyester film is taken out, and washed by water and dried.

By employing the method for producing a conductive substrate according to the present invention, a conductive substrate having a transparency and a high-level conductivity can be obtained with an excellent productivity.

Since the conductive substrate obtained by the method for producing a conductive substrate according to the present invention has a transparency and a high-level conductivity, it is possible to use it as an electromagnetic shielding film used for a flat panel display such as a plasma display panel or a liquid crystal television, and other than that, it can be suitably employed for various conductive substrate uses such as use for circuit materials or use for solar batteries.

### Examples

### [Methods for determining properties and methods for evaluating advantages]

The methods for determining properties and methods for evaluating advantages of conductive substrates prepared in the respective Examples and Comparative Examples are as follows.

### (1) Number average particle diameter of metal fine particles:

A solution dispersed with metal fine particles was dropped onto a copper mesh, and by observing it by a transmission-type electron microscope (Type: H-7100FA, produced by Hitachi Co., Ltd.), the number average particle diameter of the metal fine particles was determined. The diameters of 100 metal fine particles were measured, and the average value thereof was defined as the number average particle diameter.

### (2) Surface observation:

A metal fine particle layer of a conductive substrate was observed using a field emission scanning electron microscope (Type: JSM-6700, produced by JEOL Ltd. (a Japanese company)), and the form of the network and the width of the network portion were observed. Further, after the section of the conductive substrate was cut out, the section was observed similarly by the field emission scanning electron microscope, and the thickness of the network portion was observed.

### (3) Conductivity:

A conductivity of a metal fine particle layer of a conductive substrate was determined by a specific surface resistance. The measurement of the specific surface resistance was carried out by leaving the substrate in a regular condition (23°C, relative humidity: 65%) for 24 hours and thereafter measuring it in that atmosphere condition based on JIS-K-7194 using "Loresta-EP" (produced by Mitsubishi Chemical Corporation, Type: MCP-T360). The unit is Ω/□. Where, in this measurement device, a measurement of 1 x 10⁶Ω/□ or less is possible. In the determination, if the specific surface resistance was 10Ω/□ or less, it was determined to be Rank A and to be good in conductivity, and if the specific surface resistance was more than 10Ω/□, it was determined to be Rank B and to be not good in conductivity.

### (4) Total light transmittance:

The total light transmittance was determined using an automatic direct-reading haze computer "HGM-2DP" produced by Suga Test Instruments Co., Ltd. after leaving a conductive substrate in a regular condition (23°C, relative humidity: 65%). An average value of three measurements was defined as the total light transmittance of the conductive substrate. If the total light transmittance is 50% or more, the transparency is good. Where, in a case of a conductive substrate in which a metal fine particle layer was laminated only on one surface of a base, the conductive substrate was set so that a light entered from the side of the surface laminated with the metal fine particle layer. If the total light transmittance is 75% or more, it was determined to be Rank AA and to be more excellent in transparency, if it was 50% or more and less than 75%, it was determined to be Rank A and to be good in transparency, and if it was 50% or less, it was determined to be Rank B and to be not good in transparency.

### (5) Resistance against Moire phenomenon:

The resistance against Moire phenomenon was determined by using a "high vision plasma display" TH-42PHD7 produced by Matsushita Electric Industrial Co., Ltd. as a plasma display, holding a conductive substrate schematically in parallel to an image plane displayed with an image in front of the image plane, rotating the substrate by an angle of 360 degrees while maintaining the schematic parallel condition of the image plane and the substrate surface, and observing whether a Moire phenomenon was exhibited or not during the rotation. A condition where Moire phenomenon was not exhibited was determined to be good. Where, in a case where a random network layer was laminated only on one surface of a base, the conductive substrate was held so that the surface side on which the random network layer was not laminated faced to the display image plane.

Next, the present invention will be explained based on Examples.

### (Solution 1 for forming a metal fine particle layer)

As a solution 1 for forming a metal fine particle layer, XA-9053 produced by Fujikura Kasei Co., Ltd., which was a solution for forming a silver fine particle layer, was used. The number average particle diameter of the silver fine particles was 0.04µm.

### (Solution 2 for forming a metal fine particle layer)

As a solution 2 for forming a metal fine particle layer, CE103-7 produced by Cima NanoTech Corporation, which was a self-assembly solution for forming a silver fine particle layer in which silver fine particles were dispersed in an organic solvent, was used. The number average particle diameter of the silver fine particles was 0.08µm.

### (Solution 3 for forming a metal fine particle layer)

As a solution 3 for forming a metal fine particle layer, CE102-2 produced by Cima NanoTech Corporation, which was a solution for forming a silver fine particle layer, was used.

### Example 1:

Solution 1 for forming a metal fine particle layer was printed on one surface of a biaxially oriented polyethylene terephthalate film (produced by Toray Industries, Inc., "LUMIRROR" (registered trade mark) U94) by screen printing in a random network form. Then, a laminated substrate laminated with a silver fine particle layer in a random network form was obtained by drying the printed solution 1 for forming a metal fine particle layer at 150°C for 1 minute. The line thickness of the network was 2µm, and the line width was 50µm.

Next, as the treatment by acetone, the substrate including the film was dipped in acetone (produced by Nacalai Tesque, Inc., superior quality) at 25°C for 30 seconds, and the film was taken out and dried at 25°C for 3 minutes. Succeedingly, as the treatment by an acid, the substrate including the film was dipped in 1N (1 mol/L) hydrochloric acid (produced by Nacalai Tesque, Inc., N/1-hydrochloric acid) at 25°C for 1 minute, and the film was taken out and washed by water. Thereafter, it was dried at 150°C for 1 minute. The specific surface resistance of this film was 5Ω/□, and the total light transmittance thereof was 70%. As the result of determination against Moire phenomenon, Moire phenomenon was not exhibited.

### Example 2:

A conductive substrate was obtained in a manner similar to that in Example 1 other than a condition where it was treated with 5N (5 mol/L) hydrochloric acid (produced by Nacalai Tesque, Inc., 5N-hydrochloric acid) at 25°C. The specific surface resistance of this film was 5 Ω/□, and the total light transmittance thereof was 70%. As the result of determination against Moire phenomenon, Moire phenomenon was not exhibited.

### Example 3:

A conductive substrate was obtained in a manner similar to that in Example 1 other than a condition where it was treated with 5N (5 mol/L) hydrochloric acid (produced by Nacalai Tesque, Inc., 5N-hydrochloric acid) at 40°C. The specific surface resistance of this film was 5 Ω/□, and the total light transmittance thereof was 70%. As the result of determination against Moire phenomenon, Moire phenomenon was not exhibited.

### Example 4:

A conductive substrate was obtained in a manner similar to that in Example 1 other than a condition where it was treated with 2N (2 mol/L) hydrochloric acid (produced by Nacalai Tesque, Inc., 2N-hydrochloric acid) at 40°C. The specific surface resistance of this film was 5 Ω/□, and the total light transmittance thereof was 70%. As the result of determination against Moire phenomenon, Moire phenomenon was not exhibited.

### Example 5:

A conductive substrate was obtained in a manner similar to that in Example 1 other than a condition where it was dipped in 97% (about 18 mol/L) sulfuric acid (produced by Ishizu Seiyaku Co., Ltd., sulfuric acid 97% analytical reagent grade) at 50°C for 5 seconds. The specific surface resistance of this film was 5 Ω/□. In this Example, whitening of the polyethylene terephthalate film occurred by the acid treatment, and the total light transmittance thereof was 50%. As the result of determination against Moire phenomenon, Moire phenomenon was not exhibited.

### Example 6:

Solution 2 for forming a metal fine particle layer was applied onto a hydrophilic treated layer of a biaxially oriented polyethylene terephthalate film (produced by Toray Industries, Inc., "LUMIRROR" (registered trade mark) U46) whose one surface was treated for making it hydrophilic, and after it was left at 25°C for 10 minutes, a silver fine particle layer was laminated in a random network form, and thereafter, it was treated at 150°C for 2 minutes.

Next, as the treatment by acetone, the substrate including the film was dipped in acetone (produced by Nacalai Tesque, Inc., superior quality) at 25°C for 30 seconds, and the film was taken out and dried at 25°C for 3 minutes. Succeedingly, as the treatment by an acid, the substrate including the film was dipped in 1N (1 mol/L) hydrochloric acid (produced by Nacalai Tesque, Inc., N/1-hydrochloric acid) at 25°C for 1 minute, and the film was taken out and washed by water. Thereafter, it was dried at 150°C for 2 minutes. The specific surface resistance of this film was 4 Ω/□, and the total light transmittance thereof was 80%. As the result of determination against Moire phenomenon, Moire phenomenon was not exhibited.

### Example 7:

A conductive substrate was obtained in a manner similar to that in Example 6 other than a condition where it was treated with 5N (5 mol/L) hydrochloric acid (produced by Nacalai Tesque, Inc., 5N-hydrochloric acid) at 25°C. The specific surface resistance of this film was 4 Ω/□, and the total light transmittance thereof was 80%. As the result of determination against Moire phenomenon, Moire phenomenon was not exhibited.

### Example 8:

A conductive substrate was obtained in a manner similar to that in Example 6 other than a condition where it was treated with 5N (5 mol/L) hydrochloric acid (produced by Nacalai Tesque, Inc., 5N-hydrochloric acid) at 40°C. The specific surface resistance of this film was 4 Ω/□, and the total light transmittance thereof was 80%. As the result of determination against Moire phenomenon, Moire phenomenon was not exhibited.

### Example 9:

A conductive substrate was obtained in a manner similar to that in Example 6 other than a condition where it was treated with 2N (2 mol/L) hydrochloric acid (produced by Nacalai Tesque, Inc., 2N-hydrochloric acid) at 40°C. The specific surface resistance of this film was 4 Ω/□, and the total light transmittance thereof was 80%. As the result of determination against Moire phenomenon, Moire phenomenon was not exhibited.

### Example 10:

A conductive substrate was obtained in a manner similar to that in Example 6 other than a condition where it was dipped in 97% (about 18 mol/L) sulfuric acid (produced by Ishizu Seiyaku Co., Ltd., sulfuric acid 97% analytical reagent grade) at 50°C for 5 seconds. The specific surface resistance of this film was 4 Ω/□. In this Example, whitening of the polyethylene terephthalate film occurred by the acid treatment, and the total light transmittance thereof was 50%. As the result of determination against Moire phenomenon, Moire phenomenon was not exhibited.

### Example 11:

A conductive substrate was made in a manner similar to that in Example 1 other than a condition where a network was printed in a lattice-like form with a line thickness of 3µm, a line width of 50 µm and a pitch of 300µm. The specific surface resistance of this film was 5Ω/□, and the total light transmittance thereof was 70%. As the result of determination against Moire phenomenon, Moire phenomenon was exhibited.

### Example 12:

Solution 3 for forming a metal fine particle layer was applied onto a hydrophilic treated layer of a biaxially oriented polyethylene terephthalate film (produced by Toray Industries, Inc., "LUMIRROR" (registered trade mark) T60) whose one surface was treated for making it hydrophilic, and after it was left at 25°C for 10 minutes, a silver fine particle layer was laminated in a random network form, and thereafter, it was treated at 120°C for 1 minute. Next, the substrate including the film was dipped in acetone (produced by Nacalai Tesque, Inc., superior quality) at 25°C for 30 seconds, and the film was taken out and dried at 25°C for 3 minutes. Succeedingly, as the treatment by an acid, the substrate including the film was dipped in 0.1N (0.1 mol/L) hydrochloric acid (produced by Nacalai Tesque, Inc., N/10-hydrochloric acid) at 25°C for 2 minutes, and the film was taken out and after washed by water, it was dried at 120 °C for 1 minute. The specific surface resistance of this film was 7Ω/□, and the total light transmittance thereof was 80%. As the result of determination against Moire phenomenon, Moire phenomenon was not exhibited.

### Comparative Example 1:

Solution 2 for forming a metal fine particle layer was applied onto a hydrophilic treated layer of a biaxially oriented polyethylene terephthalate film (produced by Toray Industries, Inc., "LUMIRROR" (registered trade mark) U46) whose one surface was treated for making it hydrophilic, and after it was left at 25°C for 10 minutes, a silver fine particle layer was laminated in a random network form, and thereafter, it was treated at 150°C for 2 minutes. The specific surface resistance of this film was 100 Ω/□, and the total light transmittance thereof was 80%. As the result of determination against Moire phenomenon, Moire phenomenon was not exhibited.

### Comparative Example 2:

Solution 2 for forming a metal fine particle layer was applied onto a hydrophilic treated layer of a biaxially oriented polyethylene terephthalate film (produced by Toray Industries, Inc., "LUMIRROR" (registered trade mark) U46) whose one surface was treated for making it hydrophilic, and after it was left at 25°C for 10 minutes, a silver fine particle layer was laminated in a random network form, and thereafter, it was treated at 150°C for 2 minutes.

Next, as the treatment by acetone, the substrate including the film was dipped in acetone (produced by Nacalai Tesque, Inc., superior quality) at 25°C for 30 seconds, and the film was taken out and dried at 25°C for 3 minutes. The specific surface resistance of this film was 20 Ω/□, and the total light transmittance thereof was 80%. As the result of determination against Moire phenomenon, Moire phenomenon was not exhibited.

### Comparative Example 3:

Solution 2 for forming a metal fine particle layer was applied onto a hydrophilic treated layer of a biaxially oriented polyethylene terephthalate film (produced by Toray Industries, Inc., "LUMIRROR" (registered trade mark) U46) whose one surface was treated for making it hydrophilic, and after it was left at 25°C for 10 minutes, a silver fine particle layer was laminated in a random network form, and thereafter, it was treated at 150°C for 2 minutes.

Next, as the treatment by an acid, the substrate including the film was dipped in 1N (1 mol/L) hydrochloric acid (produced by Nacalai Tesque, Inc., N/1-hydrochloric acid) at 25 °C for 1 minute, and the film was taken out and washed by water. Thereafter, the substrate was dried at 150°C for 2 minutes. The specific surface resistance of this film was 12Ω/□, and the total light transmittance thereof was 80%. As the result of determination against Moire phenomenon, Moire phenomenon was not exhibited.

**[Table 1]**

| | Organic solvent treatment | | Acid treatment | | | Specific surface resistance/Determination | | Total light transmittance /Determination | | Moire phenomenon |
|---|---|---|---|---|---|---|---|---|---|---|
| | Temperature (°C) | Time (second) | Temperature (°C) | Concentration (mol/L) | Time (second) | (Ω/□) | Determination | (%) | Determination | |
| Example 1 | 25 | 30 | 25 | 1 | 60 | 5 | A | 70 | A | not exhibited |
| Example 2 | 25 | 30 | 25 | 5 | 60 | 5 | A | 70 | A | not exhibited |
| Example 3 | 25 | 30 | 40 | 5 | 60 | 5 | A | 70 | A | not exhibited |
| Example 4 | 25 | 30 | 40 | 2 | 60 | 5 | A | 70 | A | not exhibited |
| Example 5 | 25 | 30 | 50 | 18 | 5 | 5 | A | 50 | A | not exhibited |
| Example 6 | 25 | 30 | 25 | 1 | 60 | 4 | A | 80 | AA | not exhibited |
| Example 7 | 25 | 30 | 25 | 5 | 60 | 4 | A | 80 | AA | not exhibited |
| Example 8 | 25 | 30 | 40 | 5 | 60 | 4 | A | 80 | AA | not exhibited |
| Example 9 | 25 | 30 | 40 | 2 | 60 | 4 | A | 80 | AA | not exhibited |
| Example 10 | 25 | 30 | 50 | 18 | 5 | 4 | A | 50 | A | not exhibited |
| Example 11 | 25 | 30 | 25 | 1 | 60 | 5 | A | 70 | A | exhibited |
| Example 12 | 25 | 30 | 25 | 0.1 | 2 | 7 | A | 80 | AA | not exhibited |
| Comparative Example 1 | none | | none | | | 100 | B | 80 | AA | not exhibited |
| Comparative Example 2 | 25 | 30 | none | | | 20 | B | 80 | AA | not exhibited |
| Comparative Example 3 | none | | 25 | 1 | 1 | 12 | B | 80 | AA | not exhibited |

In Example 11, because a systematic lattice-like network was formed, Moire phenomenon was exhibited. On the other hand, in Examples 1-10 and 12, by forming the network to be random, Moire phenomenon was not exhibited.

In Examples 6-9 and 12 as compared with Examples 1-4, because the metal fine particle layers were laminated using a self-assembly solution, more preferable total light transmittances were obtained, and conductive substrates achieving both of good transparency and conductivity at a high level were obtained.

In Examples 5 and 10, because the temperature for the treatment with an acid was high and the concentration of the acid solution, the films were whitened and the total light transmittances were decreased. On the other hand, in Examples 1-4, 6-9, 11 and 12, by lowering the temperature for the treatment with an acid and lowering the concentration of the acid solution, whitening did not occur, and preferable total light transmittances were obtained.

In Comparative Examples 1-3, because the treatment with an organic solvent and/or the treatment with an acid was not carried out, the specific surface resistances were high.

### Industrial Applications of the Invention

According to the method for producing a conductive substrate of the present invention, a conductive substrate having a transparency and a high-level conductivity can be obtained with an excellent productivity. The conductive substrate produced by the method for producing a conductive substrate according to the present invention has a transparency and a high-level conductivity. Therefore, for example, it can be suitably used for a flat panel display such as a plasma display panel or a liquid crystal television.

## Claims

1. A method for producing a conductive substrate wherein a metal fine particle layer is laminated onto at least one surface of a base in a network form, comprising the steps of:
treating said metal fine particle layer with an organic solvent; and
thereafter, treating said metal fine particle layer with an acid.

2. The method for producing a conductive substrate according to claim 1, wherein said treatment of said metal fine particle layer with an acid is to dip said conductive substrate in an acid solution and/or to apply an acid solution to said conductive substrate.

3. The method for producing a conductive substrate according to claim 1, wherein said treatment of said metal fine particle layer with an acid is performed by using an acid solution having a temperature of 40°C or lower.

4. The method for producing a conductive substrate according to claim 1, wherein said treatment of said metal fine particle layer with an acid is performed by using an acid solution having a concentration of 10 mol/L or lower.

5. The method for producing a conductive substrate according to claim 1, wherein said metal fine particle layer is laminated using a solution prepared by dispersing or dissolving at least one selected from the group consisting of a metal fine particle, a metal oxide fine particle and an organic metal compound in a solvent.

6. The method for producing a conductive substrate according to claim 5, wherein said solution is a solution which is self-assembled on said base in a network form.

7. The method for producing a conductive substrate according to claim 1, wherein a number average particle diameter of metal fine particles of said metal fine particle layer is 0.2µm or less.

8. The method for producing a conductive substrate according to claim 1, wherein a specific surface resistance of said metal fine particle layer is controlled at 10Ω/□ or less by said step for treating said metal fine particle layer with an organic solvent and said following step for treating said metal fine particle layer with an acid.

9. The method for producing a conductive substrate according to claim 1, wherein said base is a thermoplastic resin film.

10. A conductive substrate made by a method for producing a conductive substrate according to any of claims 1 to 9.

11. The conductive substrate according to claim 10, wherein a total light transmittance of said conductive substrate is 50% or more.

12. An electromagnetic shielding substrate for a plasma display using a conductive substrate according to claim 10.
